# EUROPEAN PATENT APPLICATION

(11) **EP 2 808 913 A1**
(43) Date of publication of application: **03.12.2014**
(21) Application number: 13002809.5
(22) Date of filing: 31.05.2013
(51) Int. Cl.: H01L 51/00

(54) **A laminated opto-electronic device and method for manufacturing the same**

(71) Applicant: Swansea University, Swansea SA2 8PP (GB); Swansea University, Swansea SA2 8PP (GB)
(72) Inventor: Wijdekop, Maarten, Wrexham LL12 9NZ (GB); Ketipearachchi, Udaya S., 1970 CA Ijmuiden (NL); Melgari, Paolo, County Durham DH1 5AE (GB); McGettrick, James Douglas, Swansea West Glamorgan SA2 0DN (GB); Bryant, Daniel Thomas James, Swansea SA1 8DE (GB); Greenwood, Peter Clarke, Port Talbot Neath-Port Talbot SA12 6DY (GB)
(74) Representative: Ratcliffe, Susan Margaret

(57) **Abstract**

The present invention relates to a opto-electronic device which comprises:
(a) an upper device component comprising:
- a counter electrode made of a metal, a conductive oxide or a conductive organic compound;
(b) a lower device component comprising:
- a glass or polymeric carrier substrate,
- a working electrode comprising a transparent conductive coating adjacent to the glass or polymeric substrate,
- a blocking layer,
- an active layer,
- a hole conducting layer;
(c) a conductive adhesive disposed between the upper device component and the lower upper device component, and
(d) a contact layer for facilitating the injection of electrons into the active layer, between and in contact with, the conductive adhesive and the hole conducting layer.

## Description

The present invention relates to an opto-electronic device and to a process for manufacturing the same.

Opto-electronic devices encompass photo-voltaic (PV) devices that convert light into electricity and organic light emitting diodes (OLEDs) that convert electricity into light.

Dye sensitised solar cells (DSCs) are examples of PV devices that were first developed by Prof Michael Grätzel and co-workers (Nature, 353 (24) 737-740) as alternatives to expensive PV devices based on crystalline silicon. In general, DSCs comprise a working electrode, a counter electrode and an active layer that is disposed between, and in electrical contact with, the working electrode and the counter electrode for converting light into electrical energy. The working electrode (or anode) is a conductive material that receives energised electrons from the active layer, whereas the counter electrode (or cathode) is a conductive material that transports electrons back to the active layer. At least one of the electrodes should be transparent so as to allow light to reach the active layer.

In recent years attention has switched from DSC devices containing a liquid electrolyte solution of iodide/triiodide salts, to solid state dye sensitised solar cell (sDSC) devices or 'hybrid' devices, in which the liquid electrolyte is replaced by a solid hole transporting material (HTM). Other emerging hybrid solar cell technologies are Perovskite/metal-oxide heterojunction solar cells or mesoscopic solar cells (meso-superstructured solar cells, MSSC's), which are characterised by extremely thin absorber (ETA) layers. The term 'hybrid solar cells' shall be used to indicate any of the technologies mentioned hereinabove. Organic solar cells and solar cells with active materials based on Copper Indium Gallium Selenide (CIGS) or Copper Zinc Tin Sulphide (CZTS) are further examples of PV devices.

During the manufacture of sDSC devices, precious metals such as silver or gold are typically deposited on the counter electrode by a sputtering process, so as to ensure good electrical contact between the active layer and the counter electrode. However, from a manufacturing perspective, sputtering is less desirable since it takes place in a vacuum chamber, which results in an expensive and slow manufacturing process that incurs regular delays.

WO2007/005617 proposes to manufacture PV cells by a lamination method, in which the sputtered layer of silver or gold is replaced by a conductive glue based on sorbitol and PEDOT:PSS. This lamination method takes place at 120-140°C under vacuum and takes 20 minutes. The sorbitol-PEDOT:PSS glue provides an electrical connection between the active layer and the counter electrode as well providing a mechanical bond. The glue itself can be prepared by (i) adding D-sorbitol to an aqueous solution of PEDOT:PSS and spin-coating this mixture onto the electrode substrate or (ii) by spin-coating the aqueous PEDOT:PSS solution on the electrode substrate and then forming a layer of D-sorbitol on the PEDOT:PSS film, e.g. by thermal evaporation.

The overall efficiency of devices described in WO2007/005617 is severely reduced relative to solar cells that comprise sputtered layers of silver or gold. Furthermore, the 20 minute lamination process proposed in WO2007/005617 takes place at non-atmospheric conditions and elevated temperatures and is therefore not attractive from a manufacturing point of view. Both these issues hamper the commercial feasibility of the methods proposed in WO2007/005617.

It is therefore an object of the present invention to improve the efficiency of opto-electronic devices, particularly hybrid solar cell devices that are manufactured by lamination, and to enable a fast lamination process that takes place at atmospheric conditions and at room temperature.

It is another object of the invention to provide a large area opto-electronic device such as a hybrid solar cell with an active area greater than 1cm².

It is a further object of the invention to provide a continuous process for manufacturing opto-electronic devices, particularly hybrid solar cell devices.

According to a first aspect of the invention one or more the above objects are achieved by an opto-electronic device that comprises:
(a) an upper device component comprising:
   - a counter electrode made of a metal, conductive oxide, or a conductive organic compound;
(b) a lower device component comprising:
   - a glass or polymeric carrier substrate,
   - a working electrode comprising a transparent conductive coating adjacent to the glass or polymeric substrate,
   - a blocking layer,
   - an active layer,
   - a hole conducting layer;
(c) a conductive adhesive disposed between the upper device component and the lower device component, and
(d) a contact layer for facilitating the injection of electrons into the active layer, between and in contact with, the conductive adhesive and the hole conducting layer.

In order to protect the active materials of the device from coming into contact with gases and water vapour from the atmosphere, it is desirable to use a transparent carrier substrate that provides good barrier properties against both gas and water vapour. Glass carrier substrates are particularly suitable for this purpose.

The term 'transparent' generally denotes a material or layer that does not absorb a substantial amount of light in the visible portion of the electromagnetic spectrum. In the context of the present invention, transparent means that at least 60% of the light passes through the material or layer, preferably at least 70%, more preferably at least 80%.

Glass substrates with a transparent conductive coating used in accordance with the present invention preferably have an average surface roughness of less than 100 nm, which helps minimise the occurrence of electrical shorts. Glass substrates having a surface roughness of less than 100 nm are particularly effective at reducing the occurrence of electrical shorts in hybrid solar cell devices when the spacing between the electrodes is in the order of 0.5-5 µm.

An additional advantage of using glass carrier substrates with a transparent conductive coating is that they are highly transparent (> 80%), and therefore a significant portion of light is able to reach the active layer of the device. Carrier substrates made of float glass are particularly preferred.

As an alternative to glass, the carrier substrate may be made of a polymer material. Polymers are light-weight and flexible and are particularly suitable for use in a continuous roll-to-roll manufacturing process.

The working electrode must be transparent so as to allow light to reach the active layer of the device. The blocking layer is provided to prevent energised electrons in the working electrode recombining with holes in the active layer. This has the effect of reducing the occurrence of electrical shorts and electrical losses in the device. The active layer should comprise a photo-active material capable of absorbing photons and a semi-conducting material, or a material that combines both of these properties. When photons are absorbed, energised electrons are injected into the conduction band of the semi-conducting material. Electrons from the conduction band then diffuse to the working electrode and are transported to the counter electrode via an external circuit, or to the counter electrode of another cell via an interconnection. The electrons then pass through the conductive adhesive, the contact layer and the hole conducting layer before returning to the active layer for the cycle to be repeated. The hole conducting layer comprises a hole transport material (HTM), which when applied on the active layer ensures good electrical contact with the photo-active material of the active layer. The conductive adhesive is provided to make electrical contact between the HTM and the counter electrode. The conductive adhesive has the additional advantage of providing a strong mechanical bond between the upper device component and the lower device component when said components are laminated together. Since the carrier substrate is made of a transparent material such as glass, it is not necessary for the materials of the upper device component to be transparent. This means opaque materials such as metals can be used as the counter electrode. Metallic counter electrodes provide very good lateral conductivity and are therefore particularly preferred.

In addition to having good lateral conductivity, it is very important to have good conductivity in the z-direction, i.e. in the direction perpendicular to the plane of the device, between the active layer and the counter electrode, If the resistive losses are too high in the z-direction, the overall efficiency of the device is compromised. By providing a contact layer, between and in electrical contact with the conductive adhesive and the hole conducting layer, significant improvements in z-conductivity and device performance are obtained. This is due to the contact layer facilitating the extraction of electrons from the conductive adhesive and their injection into the hole conducting layer, so that they can be transported back to the active layer.

In certain cases, the conductivity in the z-direction can be increased still further by providing an upper device component that comprises a second contact layer. In this preferred embodiment a second contact layer is provided between and in electrical contact with the conductive adhesive and the counter electrode. This layer stack arrangement promotes the extraction of electrons from the counter electrode and their injection into the conductive adhesive.

In a preferred embodiment the counter electrode is provided on the surface of a transparent substrate, for instance, glass or a polymeric film substrate such as polyethylene teraphthalate (PET) or polyethylene naphthalate (PEN).

Preferably the counter electrode is provided on the surface of the transparent substrate in the form of a metallic grid. The metallic grid may be applied on a polymeric film by printing and curing conductive inks, such as silver-based inks or copper-based inks, or by laminating metallic wires, such as wires comprising iron, copper, nickel or their alloys. Since the pitch of printed and laminated grid lines tends to be an order of magnitude larger than that of counter electrodes in the form of a micro-mesh, these applied metallic grids normally benefit from a second contact layer. By applying a metallic grid counter electrode, translucent opto-electronic devices can be produced that allow light to enter and exit the opto-electronic device from either side, making such devices highly valued in the built environment.

In a preferred embodiment the counter electrode is embedded in a transparent carrier substrate that is based on a polymeric film, e,g. PET or PEN, to form a grid electrode composite. If the counter electrode, e.g. a metallic grid, is embedded in the carrier substrate, the surface facing the lower device component is flat and smooth. This makes it easier to provide subsequent coating layers such as the conductive adhesive or the second contact layer. Moreover, by having a smooth surface, the quality of the mechanical and electrical contact between the counter electrode and the subsequently applied coatings is also improved.

Preferably, the counter electrode is in the form of a metallic mesh, preferably having micrometer dimensions, and is embedded in the transparent carrier substrate. This resin-embedded mesh counter electrode is adhered to a polymeric substrate such as PET or PEN or to glass, optionally using a transparent adhesive for obtaining a stronger bond. Preferably the mesh is made of a pure metal such as copper or nickel since these offer excellent bulk conductivity. It is further preferred to provide a metallic mesh having a line width of 4-10 µm and a pitch of 50-300 µm. These meshes can achieve sheet resistance values of <1 Ohm/sq with an overall transparency of>70%.

Good efficiencies can be obtained when the opto-electronic device comprises the embedded grid or mesh counter electrode, preferably having micrometer dimensions, the conductive adhesive and the contact layer but not the second contact layer. This has the further advantage that the additional process step of providing the second contact layer is avoided.

In a preferred embodiment the embedded counter electrode comprises Al, Au, Ag, Cr, Cu, Fe, Mo or Ni. The counter electrode may consist of a single layer or multiple metallic layers. The advantage of providing a multi-layer counter electrode is that a good balance between cost, performance and durability can be realised. In a particularly preferred embodiment the counter electrode comprises a gold top-layer, preferably having a thickness of <1µm, for providing good durability and an effective electrical contact with the conductive adhesive or the second contact layer, and a copper or nickel sub-layer, preferably having a thickness between 3 and 10 µm, as an inexpensive bulk conductor.

In a preferred embodiment, the counter electrode is provided on the transparent substrate, e.g. a polymer substrate, in the form of an opaque metallic coating. Metallic coatings such as Al, Cr, Ti, Ni, Cu, Ag, Au and Mo adhere very well to both PET and PEN films and provide good barrier properties to oxygen and water vapour. The above metallic coatings or alloys thereof, additionally provide very good lateral conductivity and an effective electrical contact with the conductive adhesive or the second contact layer. These metallic coatings can be applied to polymeric films in a cost-effective way using vacuum evaporation or electron beam sputtering processes. The use of such metallised films has the additional advantage of a very low sheet resistance.

In a preferred embodiment the counter electrode is a metal or metal alloy foil or sheet. The counter electrode may be a stainless steel substrate or a steel provided with a metal or metal alloy coating, preferably comprising one or more of Ag, Al, Cr, Mo, Ni or Sn. The advantage of stainless steel is that an additional corrosion protection layer is not required, whereas the advantage of using a steel such as carbon steel is that it is relatively inexpensive to manufacture. Plated carbon steels such as nickel plated steel (eg Hilumin™), chromium and tin-plated steel such as electro-chromium coated steel (ECCS) or electrolytic tinplate (ET) are preferred. These substrates are less expensive than stainless steel and have a metallic coating that can protect the carbon steel from corrosion. Nickel plated steel and ECCS have the additional advantage of low surface roughness. It has been found that very good conductivities in the z-direction can be obtained when such plated carbon steels are provided as the counter electrode, especially when the opto-electronic device comprises the second contact layer.

In a preferred embodiment the counter electrode comprises a transparent conductive oxide coating such as tin oxide (SnO₂), zinc oxide (ZnO), aluminium zinc oxide (AZO), fluorine doped tine oxide (FTO) or indium tin oxide (ITO). These conductive oxides exhibit a sheet resistivity of 5-200 Ohm/sq and can be easily deposited onto glass substrates. ITO, ZnO and AZO coatings can also be deposited on polymer substrates. Importantly, these conductive oxides are substantially transparent (<80 %), which has the advantage that translucent opto-electronic devices can be produced which allow light to enter and exit the opto-electronic device from either side, making such devices highly valued in the built environment. The transparent conductive oxide preferably has a layer thickness between 20 and 500 nm. Although thicker layers can be provided, it is preferred not to exceed a thickness of 500 nm since this would substantially lower the transparency and increase the production costs of the transparent conductive oxide coatings. On the other hand, a layer thickness below 20 nm would not provide sufficient conductivity.

In a preferred embodiment the counter electrode comprises one or more transparent Ag coatings, which enables a better mix of sheet resistance and transparency properties.

In a preferred embodiment the transparent conductive coating comprises a transparent conductive oxide such as tin oxide (SnO₂), zinc oxide (ZnO), aluminium zinc oxide (AZO), fluorine doped tine oxide (FTO) or indium tin oxide (ITO). Glass substrates provided with one or more of the above transparent conductive oxides can be produced in a cost effective way, making them particularly suitable for commercialisation.

In a preferred embodiment the transparent conductive coating comprises at least two layers of a transparent conductive oxide selected from SnO₂, ZnO, AZO, FTO or ITO.

In a preferred embodiment the transparent conductive coating comprises one or more transparent Ag coatings, which facilitates the production process and enables a better mix of sheet resistance and transparency properties.

In a preferred embodiment the contact layer and/or the second contact layer comprise a conductive polymer such as:
(i) poly(3,4-ethylenedioxythiophene) poly(styrenesulfonate) (PEDOT:PSS) and/or derivatives thereof;
(ii) polythiophenes and/or derivatives thereof;
(iii) polyanilines and/or derivatives thereof;
(iv) polypyroles and/or derivatives thereof.

The above conductive polymers are suitable for enhancing conductivity in the z-direction. Conductive polymers such as PEDOT:PSS and/or derivatives thereof are particularly preferred for this purpose. When the contact layer comprises PEDOT:PSS. good adhesion and electrical contact between the contact layer and the hole conducting layer is obtained. Similarly, contact layers comprising PEDOT:PSS are very compatible with certain adhesive chemistries and good adhesion and electrical contact has been demonstrated between the contact layer and the conductive adhesive. Good adhesion and electrical contact also exists between the second contact layer and both the counter electrode and the conductive adhesive, resulting in a significant reduction in electrical resistance in the z-direction,

In a preferred embodiment the conductive adhesive comprises an adhesive material and a conductive material. Preferably, the adhesive material comprises polyacrylates and/or derivatives thereof since polyacrylates provide a very good mechanical bond between the upper and lower device components. Polyacrylates are also transparent meaning they are suitable for use in translucent opto-electronic devices. Preferably the conductive material comprises a conductive polymer such as poly(3,4-ethylenedioxythiophene) poly(styrenesulfonate) (PEDOT:PSS) and/or derivatives thereof. PEDOT:PSS has been found to be particularly suitable for enhancing the conductivity of the adhesive material. Very good conductivity in the z-direction is obtained when the contact layer and the conductive adhesive both contain PEDOT:PSS. Conductivity in the z-direction is further enhanced when the second contact layer is provided and contains PEDOT:PSS. Other suitable conductive polymers include polythiophenes and/or derivatives thereof, polyanilines and/or derivatives thereof and polypyroles and/or derivatives thereof. It was found that polyacrylate based adhesives are compatible with one or more of the above conductive polymers.

In a preferred embodiment the conductive adhesive comprises an adhesive material and an allotrope of carbon. Preferred carbon allotropes comprise carbon nanotubes, graphite, carbon black, fullerenes or mixtures thereof.

In a preferred embodiment the conductive adhesive contains between 0.3 and 12 wt% of the conductive polymer, preferably between 1 and 5 wt%. Conductive adhesives comprising at least 0.3 wt% conductive polymer exhibited improved conductivity in the z-direction relative to the pure transparent adhesive. When the conductive polymer content was increased to between 1 and 5 wt% a bulk conductivity of between 0.5 and 30 Siemens/cm was obtained. A bulk conductivity of between 0.1 and 30 Siemens/cm is thought to be sufficient for good z-conduction between the counter electrode and the active layer. Although the bulk conductivity of the conductive adhesive can be increased further by adding more than 12 wt% of the conductive polymer, it is preferred not to exceed 12 wt% since this lowers the tack strength of the conductive adhesive, which increases the contact resistance and reduces the transparency of the conductive adhesive. The use of higher concentrations of PEDOT:PSS also increases the cost of the conductive adhesive.

In a preferred embodiment the active surface area of the device is more than 1 cm², preferably between 10 and 500 cm², more preferably between 20 and 200 cm². The inventors found that large surface area opto-electronic devices, which may be defined as a surface of at least 1 cm², comprising the embedded or coated metal counter electrode, the contact layer and the conductive adhesive, exhibited very good fill factors because lateral resistive losses and resistive losses in the z-direction could be kept to a minimum.

In a preferred embodiment the surface roughness of the counter electrode and/or working electrode is not greater than 0.5 µm, preferably not greater than 0.3 µm. The occurrence of electrical shorting within the device is greatly reduced when the counter and/or working electrode has an average surface roughness below 0.5 µm. An average surface roughness between 0.1 and 0.3 µm is particularly preferred since significant reductions in the occurrence of electrical shorting are obtained.

A second aspect of the invention relates to a method for manufacturing an opto-electronic device, which comprises the steps of:
(a) providing an upper device component comprising
   - a counter electrode made of a metal, a conductive oxide or a conductive organic compound;
(b) providing a lower device component comprising:
   - a glass or a polymeric carrier substrate,
   - a working electrode comprising a transparent conductive coating adjacent to the glass or polymeric substrate,
   - a blocking layer,
   - an active layer,
   - a hole conducting layer,
   - a contact layer;
(c) providing a conductive adhesive on the counter electrode and/or on the contact layer;
(d) drying and curing the conductive adhesive, and
(e) laminating the upper device component and the lower device component together to form the opto-electronic device.

By laminating the upper device component and the lower device component together, opto-electronic devices can be manufactured in a cost effective manner and in high volume. It is preferred that the conductive adhesive is provided on the upper device component and that the upper device component comprising the conductive adhesive is laminated onto the lower device component. Preferably the conductive adhesive is dried and/or cured before laminating the upper device component on the lower device component. In this way damage to the active layer on the lower device component is prevented or at least reduced since the active layer is not subjected to the curing process that is employed to cure the conductive adhesive. The method has the further advantage that the upper device component and the lower device component can be manufactured independently and therefore the risk of damaging the active layer, in the form of thermal degradation or chemical reactions caused by the drying and/or curing of the conductive adhesive, is reduced.

Glass carrier substrates can be easily coated with one or more transparent conductive oxides (TCO) such as ZnO, AZO or FTO by processing techniques such as chemical vapour deposition (CVD) or physical vapour deposition (PVD). The advantage of using glass over a polymeric film made of PET or PEN is that higher temperatures can be used to deposit the transparent conductive oxide, which enables the use atmospheric deposition processes like thermal CVD. The blocking layer is preferably made of a metal oxide that is applied using a thermal deposition method. In a preferred embodiment the metal oxide is TiO₂ and is deposited using a CVD process or a PVD process. Atmospheric pressure CVD is particularly preferred since dense blocking layers, i.e. blocking layers with no, or very few pores can be obtained. Preferably the blocking layer has a thickness between 1 and 100 nm.

The active layer preferably comprises a nanoporous metal oxide that is coated with a light absorbing dye or a light absorbing inorganic material. In a preferred embodiment the active layer is formed by (i) applying a paste on the blocking layer, the paste comprising a solvent, a binder and metal oxide particles, (ii) heating the applied paste to a temperature that is chosen to remove the solvent and the binder and (iii) sintering the metal oxide at a temperature between 400°C and 600°C so as to interconnect the metal oxide particles and form a nanoporous structure. Suitable metal oxide materials include Al₂O₃, SnO₂ and TiO₂, with TiO₂ being particularly preferred. The sintered metal oxide is subsequently coated with a light-absorbing dye or light absorbing inorganic material. Preferred sensitising dyes comprise ruthenium complexes and phthalocyanines. Preferred light absorbing inorganic materials are perovskite compounds. Since the metal oxide is sintered at a temperature between 400°C and 600°C, the previously provided layers, i.e. the carrier substrate, the working electrode and the blocking layer, should also be thermally stable between 400 and 600°C. In view of this requirement, the use of TCO-coated glass carrier substrates is preferred.

Other suitable active layers comprise organic compounds only, e.g. a mixture of poly(3-hexylthiophene) (P3HT) and a fullerene derivative such as 6,6-phenyl C61-butyric acid methylester (PCBM). Alternatively, the organic semi-conductor may comprise conjugated polymers such as phthalocyanine, polyacetylene, poly(phenylene vinylene) or derivatives thereof.

The hole conducting layer comprises a hole transport material (HTM), which when applied on the active layer, fills the pores of the sintered metal oxide (after the active layer has been coated with a dye or with an inorganic light absorber), thereby ensuring good contact with the dye or inorganic absorber. As well as filling the pores, a HTM 'over-layer' having a thickness of at least 100 nm is formed on the active material. A HTM over-layer thickness of at least 100 nm ensures that electrical shorting is minimised. The hole transport material may be selected from 2,2',7,7-tetrakis-(N,N-di-p-methoxyphenyl-amine)9,9'-spirobifluorene (spiro-OMeTAD), PEDOT:PSS, copper-phthalocyanine, polythiophenes and/or derivatives thereof, polyanilines and/or derivatives thereof, polypyroles and/or derivatives thereof or inorganic compounds such as perovskites, CuI and/or their derivatives. The HTM may be applied by doctor blading, roller coating, bar coating, slot die coating or by spin coating.

The contact layer and the second contact layer preferably comprise a conductive polymer such as PEDOT:PSS. The contact layer may be applied on the hole conducting layer by screen printing, gravure printing, bar-coating or doctor-blading.

Preferably the conductive adhesive is applied by screen-printing, doctor blading, bar-coating or by roller coating since these methods provide very good deposition control when the conductive adhesive is applied as a wet film in the micrometer range.

The invention will be now be elucidated by way of example. These examples are intended to enable those skilled in the art to practice the invention and do not in anyway limit the scope of the invention as defined by the claims.
Figure 1 shows a hybrid solar cell comprising a grid counter electrode that is embedded in a transparent carrier substrate, with only the contacting area of the grid exposed at the surface. The design shown in Figure 1 is suitable for manufacturing translucent hybrid solar cell devices.
Figure 2 shows a hybrid solar cell comprising an opaque counter electrode in the form of a metal foil substrate provided with a metallic coating.
Figure 3 shows a hybrid solar cell comprising an opaque counter electrode in the form of a metallic coating provided on a polymer film carrier substrate.

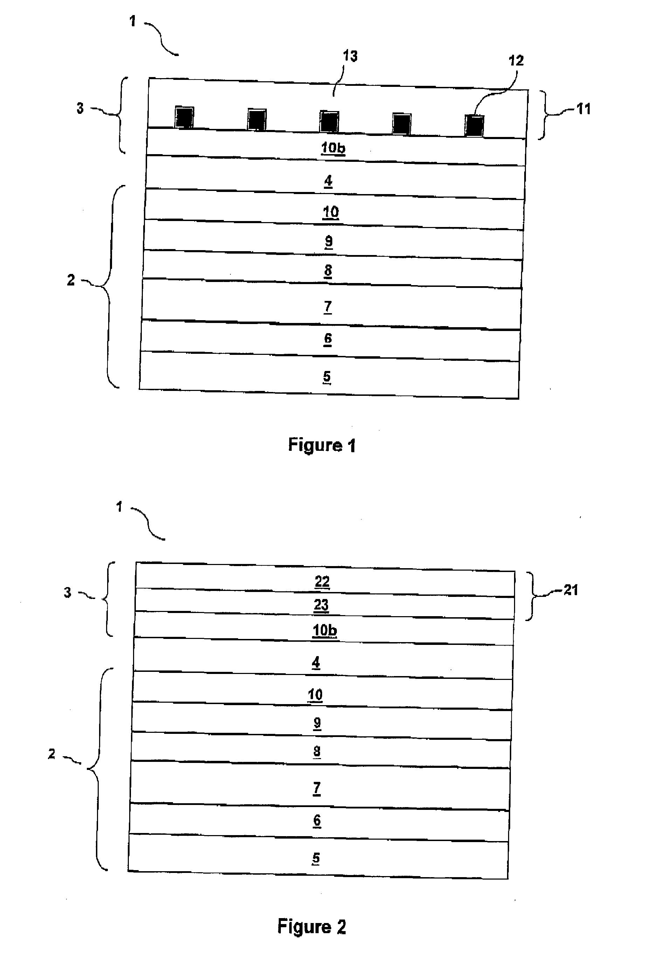

The hybrid solar cells demonstrated here are solid state dye solar cells (sDSC's), that were fabricated as follows:
The sDSC (1) according to Figure 1 comprises a lower device component (2), an upper device component (3) and a conductive adhesive (4) disposed therebetween.

The lower device component (2) is manufactured by providing a glass carrier substrate (5). Preferably the carrier substrate is made of float glass. A working electrode (6) comprising a transparent conductive oxide coating such as FTO, or a transparent metallic layer such as Ag, is applied on the glass substrate by a CVD process or a PVD process. A blocking layer (7) is then applied on the working electrode. In this example, the blocking layer is a non-porous TiO₂ coating that is applied on the working electrode by a CVD process or a PVD process.

Subsequently, an active layer (8) is applied on the blocking layer (7). In this example, a TiO₂ paste (DSL18NRT, Dyesol) is provided on the blocking layer by screen-printing. This paste is sintered at 500°C for 30 minutes in order to obtain a nanoporous TiO₂ layer having a dry film thickness of 2-3 µm. The coated glass substrate is then immersed in a solution of a dye (D102, Mitsubishi Paper Mills Ltd), 0.5mM in Acetonitrile : tert Butanol = 1:1 for 60 minutes at room temperature in order to sensitise the nanoporous TiO₂ with the dye. The dyed TiO₂ layer is then rinsed with acetonitrile to remove any excess dye, followed by immersion in isopropyl alcohol (IPA) for 10 minutes and rinsing with acetone.

A hole transport material (HTM) solution is prepared by dissolving spiro-OMeTAD (Luminescence Technology Corp.) in chloro-benzene (225mg/ml), then adding 47 µl of a LiN(SO₂CF₃)₂ stock solution (170 mg/ml in acetonitrile) and by finally adding 22 µl of tert-butyl pyridine. This HTM solution is dispensed on the active layer (50 µL for a 1cm² cell) and the solution is allowed to penetrate the pores of the dyed TiO₂ layer for 60 seconds before a spin-coater is engaged for 60 seconds at 1000 rpm. After this process, the pores of the dyed TiO₂ layer are filled with the HTM and a hole conducting layer (9) comprising the HTM material is formed on the active layer (8).

A contact layer (10) is provided on the hole conducting layer (9) to improve the electrical contact between the hole conducting layer and the conductive adhesive (4). This contact layer may be prepared by mixing a PEDOT:PSS ink (e.g. commercially available printable formulations such as EL-P-3145 from Agfa-Gevaeert NV, or SV3 from Heraeus Precious Metals GmbH & Co) with a number of suitable solvents, or by removing water from the said formulations. This solution is then bar coated on the surface of the hole conducting layer at a wet film thickness of 45 µm, and thereafter exposed to a temperature of 75°C for 12 minutes in order to remove the solvents.

The upper device component (3) comprises a grid electrode composite (11), which comprises a metallic grid (12) that is embedded in a transparent carrier substrate based on a PET film (13). The grid electrode composite used here (Epimesh 300S Gold) is a product by Epigem Ltd that comprises a nickel grid with a gold surface finish. This grid has a line width of 5 µm and a pitch of 300 µm. Using a similar method outlined for the deposition of contact layer (10), a second contact layer (10b) can be applied to the grid electrode composite to form the upper device component (3).

The conductive adhesive precursor is prepared by mixing two components together in a 1.5 : 1 ratio (v/v):
● a printable PEDOT:PSS ink formulation (e.g. EL-P-3145 from Agfa-Gevaert NV, or SV3 from Heraeus Precious Metals GmbH & Co), and
● a commercially available pressure sensitive acrylic adhesive formulation (e.g. Styccobond F46).

This mixture is stirred for approximately two minutes and then subjected to a low pressure environment to remove entrapped air. The conductive adhesive precursor is subsequently bar-coated on the upper device component (3) at a wet film thickness of 90 µm. The upper device component comprising the conductive adhesive precursor is then exposed to a temperature of 75°C for fifteen minutes to remove any low boiling point solvents contained in the conductive adhesive.

Subsequently, the upper device component (3) is exposed to a temperature of 120°C for five minutes to remove the higher boiling point solvents and other organic compounds from the mixture, This forms the conductive adhesive layer (4), which typically exhibits a bulk conductivity of 0.5 Siemens per centimetre (S/cm) when it is formulated using the said components at the given ratio.

The upper device component (3) with the conductive adhesive layer (4) is laminated at room temperature with 1 bar of mechanical pressure onto the lower device component (2) so that the conductive adhesive is in mechanical and electrical contact with the contact layer (10) and the metal grid electrode (12). According to a second example (Figure 2), the upper device component (3) comprises an opaque counter electrode in the form of a coated metal substrate (21). One or more metallic coating layers (23) may be provided on the metal foil substrate (22) to improve its chemical stability and lower its surface roughness. In this example the coated metal substrate is Hilumin™, a product from Tata Steel Europe, which is a nickel-plated steel foil.

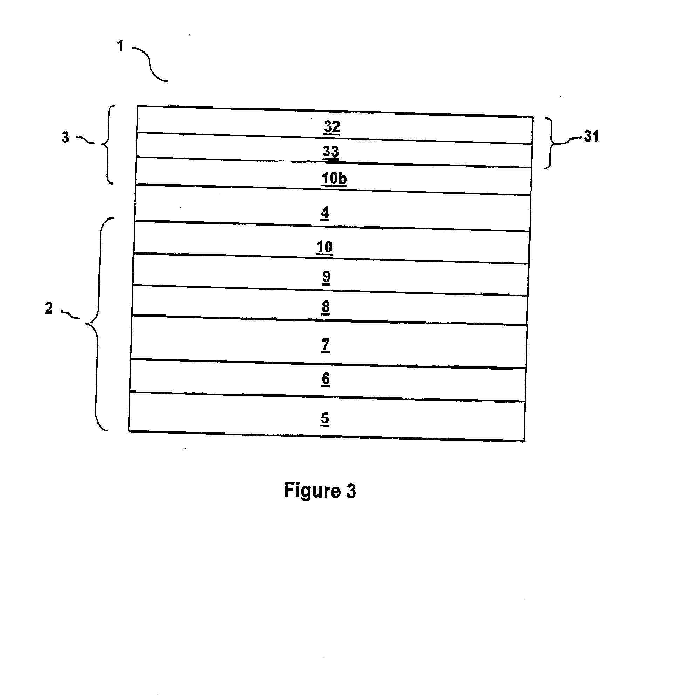

According to a third example (Figure 3), the upper device component (3) comprises an opaque counter electrode in the form of a metallised film substrate (31), which is produced by depositing a metallic coating (33) onto a polymer film (32). The metallic coating may be applied as a single layer or as a multi-layer coating, using an evaporation process or an electron beam deposition process.

To test the performance of the sDSC devices according to the first and second examples (Figures 1 and 2), I-V (current-voltage) measurements were taken using a class AAA Oriel Sol3A, solar simulator and a Keithley Instruments Model 2400 source meter. This system uses a filtered Xenon Arc lamp and light filters to simulate sunlight equivalent to the intensity of light being produced at 1 sun (100mW/cm2).

Each sDSC was tested in an identical manner, ensuring that every cell was cold and had a clean surface when it was placed in the test chamber. The I-V characteristics of the cells were obtained under an irradiation equivalent to I sun, scanning from -0.8V to 1V. From these I-V curves, the open circuit voltage (V_{OC}), the normalized short circuit current (J_{SC}), the fill factor (FF), and the efficiency have been determined, these data are given in Table 1.

**Table 1: Performance data of sDSC devices under 1 sun irradiation.**

| Cell | Glass Electrode | Counter Electrode | Area (cm²) | V_{oc} (V) | J_{sc} (mA/cm²) | FF | Efficiency (%) |
|---|---|---|---|---|---|---|---|
| (A) | FTO / TiO₂ | Ag sputtered | 1.0 | 0.879 | 4.14 | 0.442 | 1.61 |
| (B) | FTO / TiO₂ | Hilumin laminated | 1.2 | 0.764 | 7.54 | 0.321 | 1.85 |
| (C) | FTO / TiO₂ | Epimesh laminated | 1.0 | 0.748 | 10.90 | 0.495 | 4.04 |
| (D) | FTO / SnO₂ | Epimesh laminated | 1.0 | 0.712 | 10.35 | 0.421 | 3.10 |
| (E) | FTO / SnO₂ | Hilumin laminated | 1.0 | 0.712 | 9.08 | 0.325 | 2.10 |
| (F) | FTO / TiO₂ | Epimesh laminated | 8.5 | 0.712 | 5.37 | 0.519 | 1.98 |
| (G) | FTO / TiO₂ | Epimesh laminated | 8.5 | 0.694 | 3.86 | 0.540 | 1.45 |

Cells A-F were 'front illuminated', which means that light enters the device through the glass electrode. Cell G was reverse illuminated', meaning that light enters the device through the counter electrode.

All the cells presented here have a glass substrate (5) provided with a transparent conductive coating comprising Fluorine-doped Tin Oxide (FTO) that functions as the working electrode (6).

Cells A, B, C, F and G have a dense TiO₂ coating as the blocking layer (7), so for these cells the glass electrode is described as 'FTO-TiO₂'. Cells D and E have a dense SnO₂ coating as the blocking layer (7), so for these cells the glass electrode is described as 'FTO-SnO₂'. For all the cells presented here, the active layer (8), the hole conducting layer (9), the contact layer (10), the optional second contact layer (10b) and the conductive adhesive layer (4) have been prepared and deposited using the methods described above.

Cell A is a reference device which is fabricated without a contact layer or a conductive adhesive layer; it has a counter electrode based on sputtered Ag, which has been deposited directly onto the hole conducting layer in a process that took place under vacuum. This is the conventional way of providing the counter electrode to glass-based sDSC devices, and here an efficiency of 1.61 % was obtained.

For Cell B (Figure 2), a PEDOT:PSS contact layer (10) was deposited onto the hole conducting layer (9). The counter electrode in cell B is Hilumin (Nickel-plated steel). A second contact layer (10b), also based on PEDOT:PSS, is deposited on the metallic coating (23) to form the upper device component. The conductive adhesive precursor, based on a mixture of PEDOT:PSS and a pressure sensitive acrylic adhesive formulation, is applied onto the second contact layer (10b) and exposed to a multi-stage curing process to form the conductive adhesive layer (4). The two device components are then laminated together to produce a sDSC device with an efficiency of 1.85% and a FF of 0.321. It is thought that this low FF is caused by a high contact resistance between the Nickel-based metallic coating (23) and the PEDOT:PSS in the second contact layer (10b), possibly due to formation of natural oxides on the Ni surface.

Cell C (Figure 1) has the same lower device component as cell B, but the coated metal substrate (21) of cell B was replaced by a grid electrode composite (11) in the form of an Epimesh 300S Gold grid electrode. For cell C, the conductive adhesive formulation is applied directly to the grid electrode composite, without implementation of a second contact layer (10b), and subjected to the multi-stage curing process. This is then followed by lamination of the two device components, to produce an sDSC device with an impressive efficiency of 4.04%. The FF of this cell, 0.495, is substantially better than that of cell B. This is thought to be because the gold surface funish of the grid electrode composite makes very good electrical contact with the conductive adhesive (4), even without a second contact layer being present.

Cell D (Figure 1) comprises a SnO₂ blocking layer (7), while the upper device component is identical to that of cell C. The FF of cell D is 0.421, resulting in a good efficiency of 3.10%, which indicates that SnO₂ can be a suitable material for the blocking layer. It is thought that the higher surface roughness of the FTO-SnO₂ coating compared to the FTO-TiO₂ coating is responsible for the lower FF that was obtained for cell D. It is also thought that the reduced performance of cell D is because the band gap matching between the SnO₂ blocking layer and the nanoporous TiO₂ in the active layer (8) is not optimal.

Cell E has the same lower device structure as cell D, and the same upper device structure as cell B. The FF of cell E is 0.325, resulting in a lower efficiency of 2.10%. The reasons for the low FF compared to cell C are thought to be both a higher contact resistance between the Nickel-based metallic coating (23) and the PEDOT:PSS in the second contact layer (10b), and the higher roughness and/or band gap mismatching of the FTO-SnO₂ coating structure on the glass substrate.

Cells F and G have an active surface area of 8.5 cm² and are fabricated in the same way as cell C. The current of the reverse illuminated cell G is lower than that of the front illuminated cell F (3.86 vs 5.37 mA/cm²), which indicates that less light reaches the active layer (8). This is thought to be caused by a lower combined transparency of the grid electrode composite (11), the conductive adhesive (4), the contact layer (10) and the hole conducting layer (9) compared to that of the glass substrate (5), the working electrode (6) and the blocking layer (7). This difference results in the efficiency of cell F being higher than that of the reverse illuminated cell G (1.98% vs 1.45%).

Both cells F and G exhibit a good FF (0.519 and 0.540 respectively), which demonstrates that such large surface area opto-electronic devices can be fabricated using these designs without incurring prohibitive resistive losses.

## Claims

1. Opto-electronic device, which comprises:
(a) an upper device component comprising:
- a counter electrode made of a metal, a conductive oxide or a conductive organic compound;
(b) a lower device component comprising:
- a glass or polymeric carrier substrate,
- a working electrode comprising a transparent conductive coating adjacent to the glass or polymeric substrate,
- a blocking layer,
- an active layer,
- a hole conducting layer;
(c) a conductive adhesive disposed between the upper device component and the lower device component, and
(d) a contact layer for facilitating the injection of electrons into the active layer, between and in contact with, the conductive adhesive and the hole conducting layer.

2. Opto-electronic device according to claim 1, which comprises a second contact layer between, and in electrical contact with, the conductive adhesive and the counter electrode.

3. Opto-electronic device according to claim 1 or claim 2, wherein the counter electrode is provided on the surface of a transparent substrate, preferably a polymeric substrate or glass.

4. Opto-electronic device according to claim 3, wherein the counter electrode is provided in the form of a metallic grid or as a metallic coating.

5. Opto-electronic device according to claim 4, wherein the metallic counter electrode comprises Ag, Al, Au, Cr, Cu, Mo, Ni, Ti or alloys thereof.

6. Opto-electronic device according to claim 1 or claim 2, wherein the counter electrode is embedded in a transparent carrier substrate, preferably the counter electrode is in the form of a metallic grid or a metallic mesh.

7. Opto-electronic device according to claim 6, wherein the embedded metal counter electrode comprises Al, Ag, Au, Cr, Cu, Fe, Mo or Ni as a single layer or as a multi-layer.

8. Opto-electrozzic device according to claim 1 or claim 2, wherein the counter electrode is a metal or metal alloy foil or sheet, preferably steel provided with a metal or metal alloy coating comprising one or more of Ag, Al, Cr, Mo, Ni or Sn.

9. Opto-electronic device according to any one of the preceding claims, wherein the transparent conductive coating comprises at least two layers of a transparent conductive oxide selected from SnO₂, ZnO, AZO, FTO or ITO or one or more transparent Ag coatings.

10. Opto-electronic device according to any one of the preceding claims, wherein the contact layer and/or the second contact layer comprise a conductive polymer, preferably one or more of:
(i) poly(3,4-ethylenedioxythiophene) poly(styrenesulfonate) and/or derivatives thereof;
(ii) polythiophenes and/or derivatives thereof;
(iii) polyanilines and/or derivatives thereof;
(iv) polypyroles and/or derivatives thereof.

11. Opto-electronic device according to any one of the preceding claims, wherein the conductive adhesive comprises an adhesive material and a conductive material, preferably the adhesive material comprises polyacrylates or derivatives thereof.

12. Opto-electronic device according to claim 11, wherein the conductive material comprises a conductive polymer, preferably one or more of:
(i) poly(3,4-ethylenedioxythiophene) poly(styrenesulfonate) and/or derivatives thereof;
(ii) polythiophenes and/or derivatives thereof;
(iii) polyanilines and/or derivatives thereof;
(iv) polypyroles and/or derivatives thereof.

13. Opto-electronic device according to any one of the preceding claims, wherein the conductive adhesive contains between 0.3 and 12 wt% of the conductive polymer, preferably between 1 and 5 wt%.

14. Opto-electronic device according to any one of the preceding claims, wherein the active surface area of the device is more than 1 cm², preferably between 10 and 500 cm², more preferably between 20 and 200 cm².

15. Method for manufacturing an opto-electronic device, which comprises the steps of:
(a) providing an upper device component comprising:
- a counter electrode made of a metal, a conductive oxide or a conductive organic compound;
(b) providing a lower device component comprising:
- a glass or a polymeric carrier substrate,
- a working electrode comprising a transparent conductive coating adjacent to the glass or polymeric substrate,
- a blocking layer,
- an active layer,
- a hole conducting layer,
- a contact layer;
(c) providing a conductive adhesive on the counter electrode and/or on the contact layer,
(d) drying and curing the conductive adhesive, and
(e) laminating the upper device component and the lower device component to form the opto-electronic device.
